# EUROPEAN PATENT APPLICATION

(11) **EP 3 389 172 A1**
(43) Date of publication of application: **17.10.2018**
(21) Application number: 18166824.5
(22) Date of filing: 11.04.2018
(51) Int. Cl.: H02M 1/084, H02M 7/5387, H02P 27/06, G01R 19/00, H02P 6/08, H02M 1/00

(54) **CURRENT SENSE CIRCUIT FOR A DC MOTOR INVERTER**

(30) Priority: 12.04.2017 US 201715485551
(71) Applicant: Power Integrations, Inc., San Jose, CA 95138 (US)
(72) Inventor: Bäurle, Stefan, San Jose, CA California 95125 (US); Gaknoki, Yury, San Jose, CA California 95138 (US); Zhang, Michael Yue, Mountain View, CA California 94043 (US)
(74) Representative: Conroy, John

(57) **Abstract**

A system for use with a motor includes a system controller and a device coupled to the system controller. The device includes a switching element and a current sense output terminal coupled to the system controller. The current sense terminal is coupled to provide a current signal representative of the current of the switching element.

## Description

### BACKGROUND INFORMATION

### Field of the Disclosure

The present invention relates generally to motor drives. More specifically, examples of the present invention are related to brushless dc motor drives.

### Background

Household and industrial appliances such as ventilation fans, cooling systems, refrigerators, dishwasher, washer/dryer machines, and many other white products/goods typically utilize electric motors that transfer energy from an electrical source to a mechanical load. Electrical energy for driving the electric motors is provided through a drive system, which draws electrical energy from an electrical source (*e.g*., from an ac low frequency source). The electrical energy received from the electrical source is processed through a power converter, and converted to a desired form of electrical energy that is supplied to the motor to achieve the desired mechanical output. The desired mechanical output of the motor may be for example the speed of the motor, the torque, or the position of a motor shaft.

Motors and their related circuitries, such as motor drives, represent a large portion of network loads. The functionality, efficiency, size, and price of motor drives are challenging and competitive factors that suppliers of these products consider. The function of a power converter in a motor drive includes providing the input electrical signals to the motor, such as voltage, current, frequency, and phase, for a desired mechanical output load motion (e.g., spin/force) on the motor shaft. The power converter in one example may be an inverter transferring a dc input to an ac output of desired voltage, current, frequency, and phase. Controller of the power converter regulates the energy flow in response to signals that are received from a sensor block. The low power sensed signals from the motor or power converter are sent to the controller in a closed loop system by comparing the actual values to the desired values. The controller adjusts the output in comparison of the actual values to the desired values to maintain the target output.

Brushless dc (BLDC) motors, which are known for their higher reliability and efficiency, are becoming a popular choice in the market replacing brushed dc and ac motors. They are widely used in household appliances, such as refrigerators, air conditioners, vacuum cleaners, washers/driers, and other white goods, and power tools such as electric drills, or other electric tools. A BLDC motor requires a power converter, which typically includes an inverter stage as a combination of half-bridge switcher modules. A half-bridge switcher module may include power switches and control blocks inside of an integrated circuit, which provides a compact structure having a smaller size and higher efficiency.

### BRIEF DESCRIPTION OF THE DRAWINGS

Non-limiting and non-exhaustive embodiments of the present invention are described with reference to the following figures, wherein like reference numerals refer to like parts throughout the various views unless otherwise specified.
**FIG. 1** illustrates an example motor driving system including three half-bridge switcher modules coupled to a system microcontroller in accordance with the teachings of the present invention.
**FIG. 2** illustrates an example implementation of a portion of an example current sense circuit 115 included in a half-bridge switcher module of FIG. 1 in accordance with the teachings of the present invention.
**FIG. 3A** shows an example implementation of a system including multiple half-bridge switcher modules interfaced to a microcontroller in accordance with the teachings of the present invention.
**FIG. 3B** shows another example implementation of a system including multiple half-bridge switcher modules interfaced to a microcontroller in accordance with the teachings of the present invention.

Corresponding reference characters indicate corresponding components throughout the several views of the drawings. Skilled artisans will appreciate that elements in the figures are illustrated for simplicity and clarity and have not necessarily been drawn to scale. For example, the dimensions of some of the elements in the figures may be exaggerated relative to other elements to help to improve understanding of various embodiments of the present invention. Also, common but well-understood elements that are useful or necessary in a commercially feasible embodiment are often not depicted in order to facilitate a less obstructed view of these various embodiments of the present invention.

### DETAILED DESCRIPTION

In the following description, numerous specific details are set forth in order to provide a thorough understanding of the present invention. It will be apparent, however, to one having ordinary skill in the art that the specific detail need not be employed to practice the present invention. In other instances, well-known materials or methods have not been described in detail in order to avoid obscuring the present invention.

Reference throughout this specification to "one embodiment", "an embodiment", "one example" or "an example" means that a particular feature, structure or characteristic described in connection with the embodiment or example is included in at least one embodiment of the present invention. Thus, appearances of the phrases "in one embodiment", "in an embodiment", "one example" or "an example" in various places throughout this specification are not necessarily all referring to the same embodiment or example. Furthermore, the particular features, structures or characteristics may be combined in any suitable combinations and/or subcombinations in one or more embodiments or examples. Particular features, structures or characteristics may be included in an integrated circuit, an electronic circuit, a combinational logic circuit, or other suitable components that provide the described functionality. In addition, it is appreciated that the figures provided herewith are for explanation purposes to persons ordinarily skilled in the art and that the drawings are not necessarily drawn to scale.

In the context of the present disclosure, when a transistor is in an "off state", or "off", the transistor does not substantially conduct current. Conversely, when a transistor is in an "on state", or "on", the transistor is able to substantially conduct current. By way of example, in one embodiment, a high-voltage transistor comprises an N-channel metal-oxide-semiconductor field-effect transistor (NMOS) with the high-voltage being supported between the first terminal, a drain, and the second terminal, a source. The high voltage MOSFET comprises a power switch, which when included for instance in an example motor driving system, is driven by an integrated controller circuit to regulate energy provided to a load. For purposes of this disclosure, "ground" or "ground potential" refers to a reference voltage or potential against which all other voltages or potentials of an electronic circuit or integrated circuit (IC) are defined or measured.

BLDC motors are becoming increasingly popular in household appliances and power tools. Some of the main reasons why BLDC motors are becoming increasingly popular are due to their higher efficiency and reliability, and less audible noise compared to brushed or universal motors. BLDC motors are typically driven with 2-phase or 3-phase inverters through half-bridge switcher configurations. High voltage BLDC motors offer better efficiency and lower cost compared to their low voltage (LV) counterparts. The off-line motor drives typically run off of a rectified ac mains (*e.g*., 325 Vdc bus), or from a power factor correction (PFC) stage output (*e.g.,* a 395 Vdc bus).

Motor drives using half-bridge or full-bridge based inverters require (high voltage) HV switch current information for controlling torque of BLDC or AC induction motors. Inverters with half-bridge switching configurations are commonly used with motor drives. Instead of implementing a full bridge switching configuration, utilizing a half-bridge switching circuit with low-side and high-side control blocks inside one single package (*e.g.,* a module) allows support for multiphase inverters, such 2-phase and 3-phase inverters, that provide increased layout flexibility as well as simplified thermal management for each module. Utilization of a modular half-bridge circuit structure for a motor drive inverter may reduce overall system cost because of a variety of reasons.

Many applications for controlling the motor and for overcurrent fault protection, require current sensing of any of the power switches (*e.g*., MOSFETs) in the half-bridge switching circuit structure. Existing solutions for sensing MOSFET currents require costly external circuitry including shunt resistors, capacitors, filters, level shifters, op-amps, references, and other active or passive electrical components. A current sensing circuit integrated with the half-bridge switcher circuit may remove the need for costly external circuitry. Furthermore, providing the current sense output on a single terminal, or through a single current sense wire, may provide a convenient interface to the microcontroller.

As will be discussed, an apparatus and methods of a power switch (MOSFET) instantaneous current sense circuit in a half-bridge inverter module are disclosed in accordance with the teachings of the present invention. In one example, the sensed current is the instantaneous drain to source current of the low side (LS) MOSFET, which is representative of an instantaneous phase current of the motor. In other examples, the instantaneous current may be the drain to source current of the high side (HS) MOSFET. Advantageously, the sensed drain to source MOSFET current may eliminate any sensed current through the internal body diode of the MOSFET. This may further eliminate the need of external circuitry for having a DC offset such as level shifters, which may otherwise be needed for interface to a system microcontroller. As will be shown, examples in accordance with the teachings of the present invention provide reduced pin count usage on a system interface with the system controller (µC).

The descriptions below explain in detail an example single terminal power switch (MOSFET) current sensing feature based on embodiments of the present disclosure. Even though in example figures and description of the present disclosure describe a single half-bridge inverter module for explanation purposes, and specifically with a load example of multi-phase motor drive (in one example, a BLDC motor), it is understood by someone skilled in the art that the embodiment of the disclosed invention may be used with any multi switching module or other multi devices controlled by a system controller wherein the multi devices/switching modules by their current sensing terminals are coupled to the system controller via/through a single-terminal. It is also understood that the system controller for switching modules may be included in a variety of microcontrollers, microprocessors, digital signal processor (DSP) controllers, or the like.

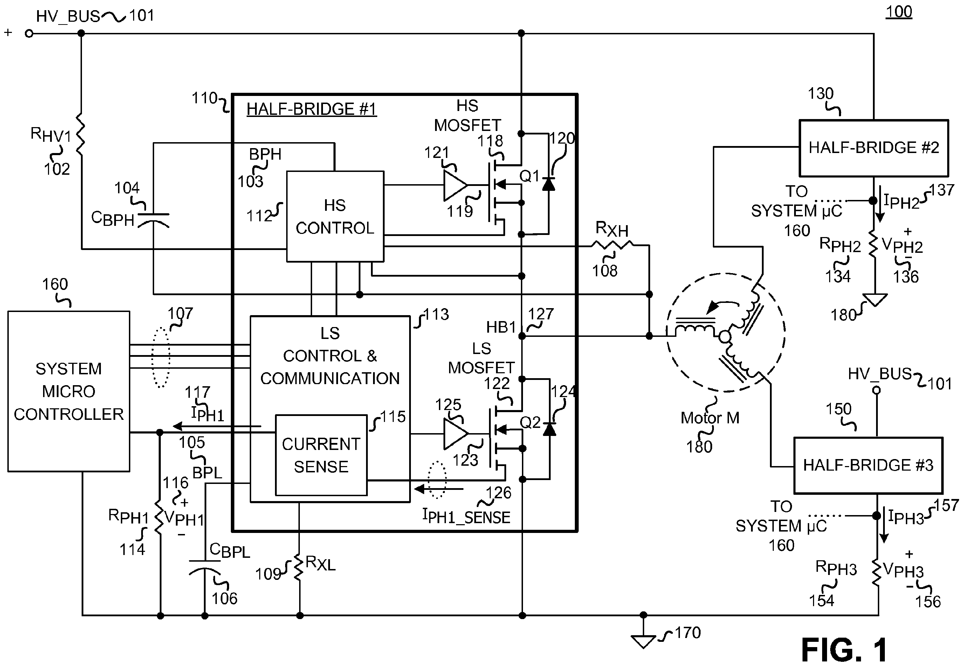

**FIG. 1** illustrates an example motor driving system 100 including three half-bridge switcher modules, half-bridge module #1 110, half-bridge module #2 130, and half-bridge module #3 150, which are coupled to a system microcontroller in accordance with the teachings of the present invention. It is noted that **FIG. 1** shows the details of example control circuit blocks and their signals included in one of the half-bridge modules (*i.e.,* half-bridge module #1 110), and that details of the other half-bridge modules, (*i.e.,* half-bridge module #2 130 and half-bridge module #3 150) although present, are not shown in detail so as to avoid obscuring the teachings of the present invention.

As shown in the depicted example, motor driving system 100 includes a BLDC motor M 180, a first half-bridge module #1 110, a second half-bridge module #2 130, a third half-bridge module #3 150, a system microcontroller 160, resistor R_{HV1} 102, phase current signal resistors R_{PH1} 114, R_{PH2} 134, and R_{PH3} 154, a high-side resistor R_{XH} 108, a low-side resistor R_{XL} 109, a high-side bypass capacitor C_{BPH} 104, and a low-side bypass capacitor C_{BPL} 106. In various examples, it is appreciated that motor M 180 may be considered a multi-phase load or ac load. The system microcontroller 160 is coupled exchange control signals 107 with the LS Control & Communication circuit 113. In the depicted example, BPH 103 is a supply terminal to the high-side controller of half-bridge modules #1 110, and BPL 105 is the supply terminal to the low-side controller of the half-bridge module #1 110. Although not shown in **FIG. 1****,** the half-bridge modules 130 and 150 also include the supply terminals to their respective high-side and low-side controllers. Similarly, the bypass capacitors C_{BPL} 106 and C_{BPH} 104 are coupled to deliver sufficient gate charge to turn on the internal LS and HS MOSFET devices. They may also be coupled to provide LS and HS driver bias currents. The high-side supply terminal BPH 103 is referenced to the half-bridge point HB1 127 through the bypass capacitor C_{BPH} 104. The first half-bridge module #1 110 is coupled to sense the high dc voltage from the dc bus HV_BUS 101 via the resistor R_{HV1} 102. In other examples, the second half-bridge module #2 130 or a third half-bridge module #3 150 may also be coupled to receive the high dc voltage from the dc bus HV_BUS 101, via respective resistors (not shown in **FIG. 1**)

**FIG. 1** further illustrates internal circuit details of the first half-bridge module #1 110, which is shown to include an HS control circuit 112, LS control and communication circuit 113, an HS MOSFET Q1 118, a gate driver 121 for Q1 118, an LS MOSFET Q2 122, and a gate driver 125 for Q2. Although not shown in **FIG. 1****,** half-bridge module #2 130 and half-bridge module #3 150 also include similar internal circuit blocks as half-bridge module #1 110. Half-bridge module #2 130 is coupled to output a low-side power switch current at a terminal I_{PH2} 137 and Half-bridge module #3 150 is coupled to output a low-side power switch current at a terminal I_{PH3} 157. The current signal outputs at I_{PH1} 117, I_{PH2} 137, and I_{PH3} 157 may be converted to voltage signals V_{PH1} 116, V_{PH2} 136, and V_{PH3} 156 via the resistors R_{PH1} 114, R_{PH2} 134, and R_{PH3} 154, respectively. In the depicted examples, each of the current signal outputs at I_{PH1} 117, I_{PH2} 137, and I_{PH3} 157 may provide a respective current sense signal via a single current sense wire or a single terminal. The low-side controllers of all three half-bridge modules 110, 130, and 150 are referenced to a common return 170.

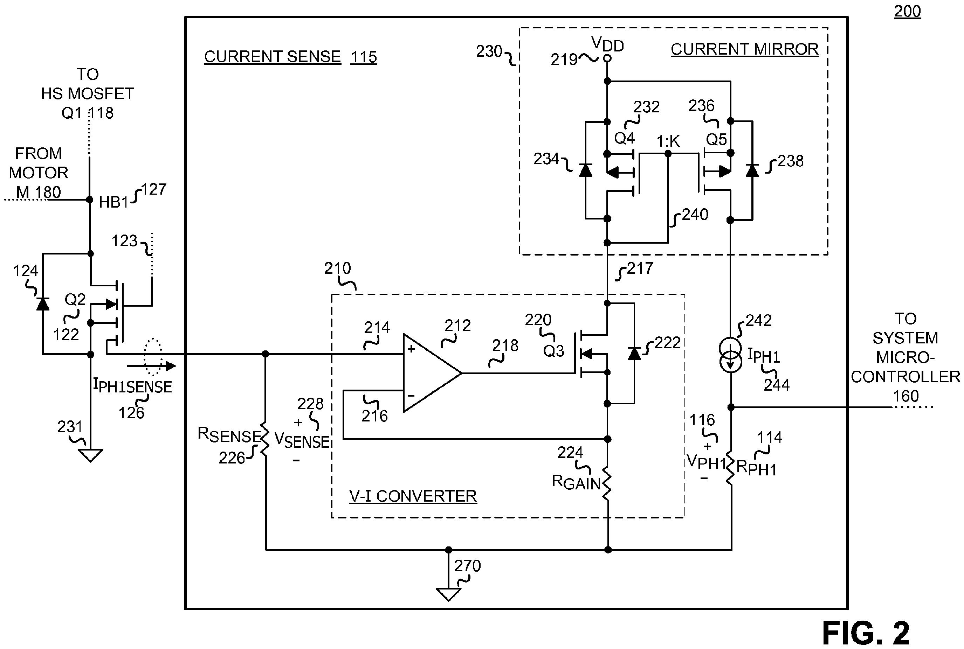

In one example, the HS control circuit 112 is coupled to the control terminal (*i.e*., gate) 119 of the HS MOSFET Q1 118 via the gate driver 121, and the LS control & communication circuit 113 is coupled to the control terminal (*i.e.,* gate) 123 of the LS MOSFET Q2 122 via the gate driver 125. In the described example, the HS MOSFET Q1 118 and the LS MOSFET Q2 122 are senseFETs, which are current sensing power MOSFETs. Furthermore, the drain terminal of the HS MOSFET Q1 118 is coupled to the HV bus 101. The source terminal of the LS MOSFET Q2 122 is coupled to the return 170. The source terminal of the HS MOSFET Q1 118 is coupled to the drain terminal of LS MOSFET Q2, which is further coupled to one of the phase inputs of the motor M 180 via a half-bridge point HB1 127. It is appreciated that the half-bridge point HB1 127 may therefore be a mid-point terminal that is coupled between HS MOSFET Q1 118 and the LS MOSFET Q2 122, and coupled to one phase of a multi-phase load or ac load. It is also appreciated that HS MOSFET Q1 118 and the LS MOSFET Q2 122 may also be referred to as a switching block, which includes HS MOSFET Q1 118 coupled to LS MOSFET Q2 122, and the mid-point terminal HB1 127 between HS MOSFET Q1 118 and LS MOSFET Q2 122 coupled to the respective phase terminal of the multiphase load of Motor M 180. The diodes 120 and 124 represent internal body diodes of transistors Q1 118 and Q2 122 respectively. The current sense circuit 115 is coupled to receive the drain current of the LS MOSFET Q2 122 via a signal I_{PH1_SENSE} 126. The current sense circuit 115, the details of which will be discussed in greater detail below in **FIG. 2****,** is further coupled to sense and output the sensed current at the terminal I_{PH1} 117.

**FIG. 2** illustrates further details of an example current sense circuit 115, which may be an example of the current sense circuit 115 included in the LS control and communication circuit 113 of the half-bridge #1 of **FIG. 1****.** As shown the current sense circuit 115 is coupled to receive the drain current sense signal I_{PH1_SENSE} 126 of the LS MOSFET Q2 122. The current sense circuit 115 further includes a current mirror 230 and V-I converter 210. In one example, the V-I converter 210 includes an op-amp 212, a transistor 220, and a resistor R_{GAIN} 224. The current mirror 230 further includes a transistor Q4 232 and a transistor Q5 236. The source terminals of both transistors Q4 232 and Q5 236 are coupled to a supply voltage VDD 219. The diodes 222, 234, and 238 represent internal body diodes of transistors Q3 220, Q2 122, and Q5 236 respectively. In the described example, Q3 220 is an NMOS transistor, and Q4 232 and Q5 236 are PMOS transistors. In other examples, Q3 220 may be a PMOS transistor, and Q4 232 and Q5 236 are NMOS transistors. Additionally, the circuits may be realized using any combination of various types of transistors. Also shown in **FIG. 2** are a current sense resistor R_{SENSE} 226, a current source 242, and a resistor R_{PH1} 114.

The V-I converter 220 may be considered as a variable current source. A control terminal of the transistor Q3 220 is coupled to receive the output 218 of the op-amp 212. The transistor Q3 220 is coupled as a current source, and therefore the term current source or transistor may be used interchangeably when referring to Q3 220 of the V-I converter 210. **FIG. 2** also shows a current sense resistor R_{SENSE} 226 having one end coupled to the non-inverting input terminal 214 of the op-amp 212 and the other end coupled to the input return 270. The sensed current I_{PH1 SENSE} 126 develops a voltage V_{SENSE} 228 across the current sense resistor R_{SENSE} 226. In one example, the V-I converter 210, and more specifically a non-inverting input terminal 214 of the op-amp 212 of the V-I converter 210 is coupled to receive a voltage signal V_{SENSE} 228, which is substantially equal to the voltage developed across the current sense resistor R_{SENSE} 226. In one example, the op-amp 212 is coupled as an error amplifier. An inverting input terminal 216 of the op-amp 212 and the source terminal of the MOSFET Q3 220 are coupled to one end of the resistor R_{GAIN} 224. The other end of the resistor R_{GAIN} 224 is coupled to the input return 270.

As the value of the LS MOSFET drain current signal I_{PH1_SENSE} 126 varies the current through the transistor Q3 220 may also vary in response to I_{PH1_SENSE} 126. One end of the transistor Q4 232 of the current mirror 230 is coupled to receive an output 217 of the V-I converter 220. The drain of transistor Q4 232 is coupled to the drain of transistor Q3 220 and to its gate. The gates of transistor Q4 232 and transistor Q5 236 are coupled together through coupling 240. The output of current mirror 230 is coupled to a current source 242. As the current through transistor Q3 220 varies, the gate bias of transistor Q4 232 and the gate bias of transistor Q5 236 vary accordingly. Thus, the magnitude of the current I_{PH1} 244 through the current source 242 varies in response to the instantaneous drain current I_{PH1_SENSE} 126. The voltage V_{PH1} 116 generated across the resistor R_{PH1} 114 by the current I_{PH1} 244 may also vary accordingly, and may be used to interface to the system controller 160, or system microcontroller, as shown in **FIG. 1****.**

The ratio of the values of the respective currents through Q4 232 and Q5 236 as shown by 1:K is proportional to the ratio of the value of the resistors R_{SENSE} 226 to R_{GAIN} 224. In one example, the ratio 1:K is equal to 1A to 100 µA.

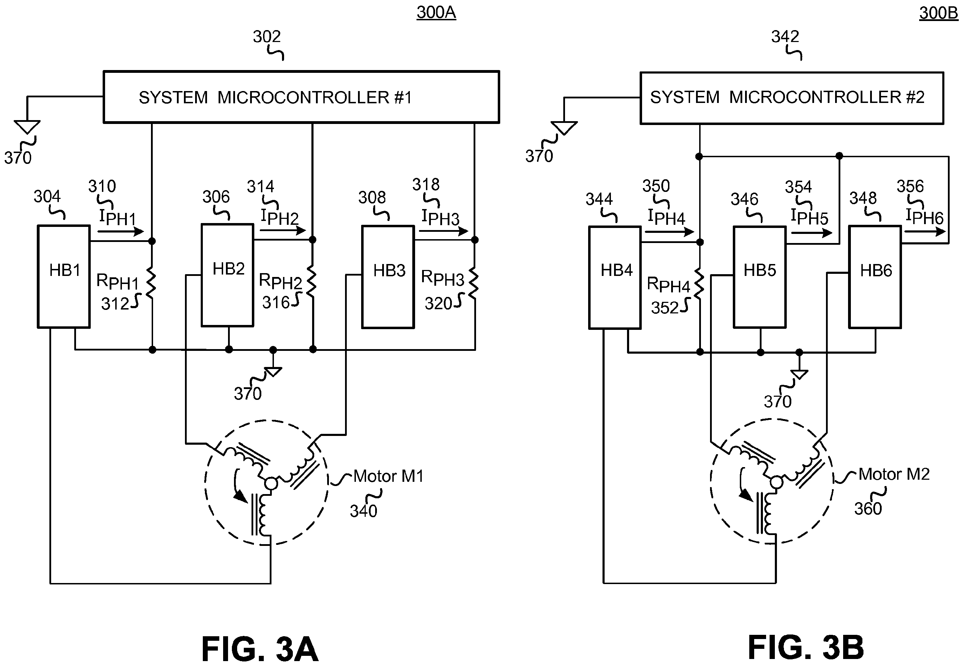

**FIGs. 3A** and **3B** show example implementations of a systems 300A and 300B, which include multiple half-bridge switcher modules interfaced to microcontrollers in accordance with the teachings of the present invention. **FIG. 3A** includes a system microcontroller #1 302 coupled to drive a motor M1 340 via half-bridge modules HB1 304, HB2 306, and HB3 308, as shown for example in **FIG. 1****.** **FIG. 3B** also includes a system microcontroller #2 342, which is coupled to drive a motor M2 360 via half-bridge modules HB4 344, HB5 346, and HB6 348. As illustrated in **FIG. 3A****,** the half-bridge modules HB1 304, HB2 306, and HB3 308 are coupled to the return 370 via the phase current signal resistors R_{PH1} 312, R_{PH2} 316, and R_{PH3} 320 respectively. Similarly as illustrated in **FIG. 3B** the half-bridge modules HB4 344, HB5 346, and HB6 348 are coupled to the return 370 via a phase resistor R_{PH4} 352.

A difference between systems 300A and 300B is that in system 300A, each half-bridge module is coupled to provide individual phase current signals namely I_{PH1} 310, I_{PH2} 314, and I_{PH3} 318 to the system microcontroller #1 302. In some examples, this may allow easier implementation of motor control algorithms when two or more LS MOSFETs are on at a given time. In system 300B, however, all the half-bridge modules HB4 344, HB5 346, and HB6 348 are coupled to provide to the system microcontroller #2 342 through a single current sense wire a single composite phase current signal, which is representative of all the phase currents from the windings. In some examples, this may allow a simplified of implementation of motor control algorithms where only a single LS power MOSFET is on at a given time. In one example, a system with multiple phase resistors, as shown for instance in system 300A, and a system with a single phase resistor, as shown for instance in system 300B, may be combined to drive multiple motors.

The above description of illustrated examples of the present invention, including what is described in the Abstract, are not intended to be exhaustive or to be limitation to the precise forms disclosed. While specific embodiments of, and examples for, the invention are described herein for illustrative purposes, various equivalent modifications are possible without departing from the broader spirit and scope of the present invention. Indeed, it is appreciated that the specific example voltages, currents, frequencies, power range values, times, etc., are provided for explanation purposes and that other values may also be employed in other embodiments and examples in accordance with the teachings of the present invention.

### EMBODIMENTS

Although the present invention is defined in the attached claims, it should be understood that the present invention can also (alternatively) be defined in accordance with the following embodiments:
1. A system for use with a motor, comprising:
   a system controller; and
   a device coupled to the system controller, wherein the device comprises:
      a switching element; and
      a current sense output terminal coupled to the system controller, wherein the current sense terminal is coupled to provide a current signal representative of the current of the switching element.
2. The system of embodiment 1, wherein the device includes a current sense circuit coupled to sense a current signal of the switching element.
3. The system of embodiment 2, wherein the current sense circuit comprises:
   a voltage-to-current converter circuit coupled to sense an instantaneous value of a current signal of the switching element; and
   a current mirror circuit coupled to the voltage-to-current converter circuit to provide a fixed current proportional to the instantaneous value of the current signal.
4. The system of embodiment 3, wherein the voltage-to-current converter circuit further comprises an op-amp and a transistor,
   wherein an input terminal of the op-amp is coupled to receive a voltage representative of the instantaneous value current signal, and
   wherein an output of the op-amp is coupled to a control terminal of the transistor.
5. The system of embodiment 4, wherein an output of the voltage-to-current converter circuit is coupled to the current mirror circuit, and wherein the output of the current mirror circuit is coupled to a current source.
6. The system of embodiment 1, wherein the switching element is a MOSFET.
7. A switching module for use in a current sensing system, wherein the switching module is coupled to an input voltage to generate a desired output to a load in response to a system controller, wherein the switching module comprises:
   a low side switch;
   a low side control circuit coupled to control the low side switch, wherein the low side control circuit is referenced to a low side reference ground;
   a high-side switch coupled to the low side switch;
   a high-side control circuit coupled to control the high-side switch;
   a current sense output terminal coupled to the system controller to provide an instantaneous representative current value of the low side switch current to the system controller.
8. The switching module of embodiment 7, wherein the low side switch is a MOSFET and the low side switch current is a drain to source current of the MOSFET.
9. The switching module of embodiment 7, further comprising a resistor coupled to the current sense output terminal coupled to provide a sense voltage to the system controller.
10. The switching module of embodiment 7, wherein the system controller is one of a microcontroller, microprocessor, or a digital signal processor controller.
11. The switching module of embodiment 7, further comprising a mid-point terminal coupled between the high side switch and the low side switch, and coupled to one phase of a multi-phase load.
12. The switching module of embodiment 11, wherein the multi-phase load is a multiphase motor, wherein the mid-point terminal is coupled to respective phase terminal of the multiphase motor.
13. The switching module of embodiment 12, wherein he multiphase motor is a brushless DC motor.
14. A current sensing system for use with a plurality of half-bridge inverter modules, comprising:
   a single current sense wire;
   a system controller coupled to the current sense wire; and
   the plurality of half-bridge inverter modules coupled to an ac load in response to the system controller, wherein each one of the plurality of half-bridge inverter modules comprises:
      a single current sense output terminal coupled to the single current sense wire to provide an instantaneous current value of the low side switch to the system controller;
      a switching block including a high side switch coupled to a low side switch, wherein a mid-point terminal between the high side switch and the low side switch is coupled to a respective phase terminal of the multiphase load.
15. The system of embodiment 14, wherein the system controller is a microcontroller, microprocessor, or a digital signal processor controller.
16. The system of embodiment 14, wherein the plurality of half-bridge inverter modules are coupled to drive a multiphase motor.
17. A multiphase motor drive system, comprising:
   a multiphase motor having a plurality of phase input terminals;
   a current sense wire;
   a system controller coupled to the current sense wire;
   a high voltage bus; and
   a plurality of half-bridge inverter modules coupled to the high voltage bus and the fault bus, wherein each one of the plurality of half-bridge inverter modules comprises:
      a switching block coupled to the high voltage bus, and including a high side switch coupled to a low side switch, wherein a mid-point terminal between the high side switch and the low side switch is coupled to a respective one of the plurality of phase input terminals of the multiphase motor;
      a high side control block coupled to drive the high side switch in response to high side gating signals from the system controller;
      a low side control and communication block coupled to the drive the low side switch in response to low side gating signals from the system microcontroller; and
      a current sense terminal coupled to provide an instantaneous current value of the low side or the high side switch to the system controller.

## Claims

1. A system for use with a motor, comprising:
a system controller; and
a device coupled to the system controller, wherein the device comprises:
a switching element, for example, a MOSFET; and
a current sense output terminal coupled to the system controller, wherein the current sense terminal is coupled to provide a current signal representative of the current of the switching element.

2. The system of claim 1, wherein the device includes a current sense circuit coupled to sense a current signal of the switching element.

3. The system of claim 2, wherein the current sense circuit comprises:
a voltage-to-current converter circuit coupled to sense an instantaneous value of a current signal of the switching element; and
a current mirror circuit coupled to the voltage-to-current converter circuit to provide a fixed current proportional to the instantaneous value of the current signal.

4. The system of claim 3, wherein the voltage-to-current converter circuit further comprises an op-amp and a transistor,
wherein an input terminal of the op-amp is coupled to receive a voltage representative of the instantaneous value current signal, and
wherein an output of the op-amp is coupled to a control terminal of the transistor.

5. The system of claim 4, wherein an output of the voltage-to-current converter circuit is coupled to the current mirror circuit, and wherein the output of the current mirror circuit is coupled to a current source.

6. A switching module for use in a current sensing system, wherein the switching module is coupled to an input voltage to generate a desired output to a load in response to a system controller, wherein the switching module comprises:
a low side switch;
a low side control circuit coupled to control the low side switch, wherein the low side control circuit is referenced to a low side reference ground;
a high-side switch coupled to the low side switch;
a high-side control circuit coupled to control the high-side switch;
a current sense output terminal coupled to the system controller to provide an instantaneous representative current value of the low side switch current to the system controller.

7. The switching module of claim 6, wherein the low side switch is a MOSFET and the low side switch current is a drain to source current of the MOSFET.

8. The switching module of claim 6, further comprising a resistor coupled to the current sense output terminal coupled to provide a sense voltage to the system controller.

9. The switching module of claim 6, wherein the system controller is one of a microcontroller, microprocessor, or a digital signal processor controller.

10. The switching module of claim 6, further comprising a mid-point terminal coupled between the high side switch and the low side switch, and coupled to one phase of a multi-phase load.

11. The switching module of claim 10, wherein the multi-phase load is a multiphase motor, wherein the mid-point terminal is coupled to respective phase terminal of the multiphase motor, for example, wherein the multiphase motor is a brushless DC motor.

12. A current sensing system for use with a plurality of half-bridge inverter modules, comprising:
a single current sense wire;
a system controller coupled to the current sense wire; and
the plurality of half-bridge inverter modules coupled to an ac load in response to the system controller, wherein each one of the plurality of half-bridge inverter modules comprises:
a single current sense output terminal coupled to the single current sense wire to provide an instantaneous current value of the low side switch to the system controller;
a switching block including a high side switch coupled to a low side switch, wherein a mid-point terminal between the high side switch and the low side switch is coupled to a respective phase terminal of the multiphase load.

13. The system of claim 12, wherein the system controller is a microcontroller, microprocessor, or a digital signal processor controller.

14. The system of claim 12, wherein the plurality of half-bridge inverter modules are coupled to drive a multiphase motor.

15. A multiphase motor drive system, comprising:
a multiphase motor having a plurality of phase input terminals;
a current sense wire;
a system controller coupled to the current sense wire;
a high voltage bus; and
a plurality of half-bridge inverter modules coupled to the high voltage bus and the fault bus, wherein each one of the plurality of half-bridge inverter modules comprises:
a switching block coupled to the high voltage bus, and including a high side switch coupled to a low side switch, wherein a mid-point terminal between the high side switch and the low side switch is coupled to a respective one of the plurality of phase input terminals of the multiphase motor;
a high side control block coupled to drive the high side switch in response to high side gating signals from the system controller;
a low side control and communication block coupled to the drive the low side switch in response to low side gating signals from the system microcontroller; and
a current sense terminal coupled to provide an instantaneous current value of the low side or the high side switch to the system controller.
